# EUROPEAN PATENT SPECIFICATION

(11) **EP 2 848 877 B1**
(45) Date of publication and mention of the grant of the patent: **09.06.2021**
(21) Application number: 14184899.4
(22) Date of filing: 16.09.2014
(51) Int. Cl.: F25B 31/00, F25B 13/00, F25B 40/02

(54) **Air conditioner**
Klimaanlage
Climatiseur

(30) Priority: 16.09.2013 KR 20130110929
(43) Date of publication of application: 18.03.2015
(73) Proprietor: LG ELECTRONICS INC., Yeongdeungpo-Gu Seoul 150-721 (KR)
(72) Inventor: Lee, Hakjin, 153-802 Seoul (KR); Kim, Taegeol, 153-802 Seoul (KR); Jang, Seokhoon, 153-802 Seoul (KR)
(74) Representative: Vossius & Partner Patentanwälte Rechtsanwälte mbB

(56) References cited:
- EP-A1- 0 933 603
- EP-A1- 2 314 940
- EP-A1- 2 522 931
- WO-A1-2013/001829
- US-A1- 2010 101 242

## Description

### BACKGROUND

The present disclosure relates to an air conditioner.

Air conditioners are home appliances that maintain indoor air in the most proper state according to use and purpose. For example, such an air conditioner controls indoor air in a cold state in summer and controls indoor air in a warm state in winter. Furthermore, the air conditioner controls humidity of the indoor air and purifies the indoor air to become in a pleasant and clean state.

In detail, the air conditioner has a refrigerant cycle in which compression, condensation, expansion, and evaporation processes of a refrigerant are performed. Thus, a cooling or heating operation of the air conditioner may be performed to cool or heat the indoor air according to the refrigerant cycle.

The air conditioners may be classified into split type air conditioners in which indoor and outdoor units are separated from each other and integral type air conditioners in which indoor and outdoor units are integrally coupled to each other as a single unit according to whether the indoor and outdoor units are separated from each other. The outdoor unit includes an outdoor heat exchanger heat-exchanging with external air, and the indoor unit includes an indoor heat exchanger heat-exchanging with indoor air.

When a refrigerant cycle performs a cooling operation, the outdoor heat exchanger serves as a condenser and the outdoor heat exchanger serves as an evaporator. On the other hand, when the refrigerant cycle performs a heating operation, the indoor heat exchanger serves as the condenser and the outdoor heat exchanger serves as the evaporator.

An electronic unit for driving the air conditioner is disposed within the outdoor unit. The electronic unit includes a plurality of control components. While the air conditioner is driven, a large amount of heat may be generated from the electronic units. The electronic unit may generate heat having a temperature of about 70°C to about 80°C.

In the air conditioner according to the related art, if the electronic unit is not sufficiently cooled, malfunction of the control components may occur. As a result, the function (heat exchange operation) of the air conditioner may not be sufficiently performed, or the air conditioner may be broken down. An air conditioner according to the preamble of claim 1 is shown in EP-A-2 314 940.

To cool the electronic unit, a board having high thermal conductivity may be disposed on a side of the electronic unit, and then a device (e.g., a heat-sink) that is heat-exchanged with external air may be provided in the air conditioner according to the related art.

However, the heat-sink manner may have a limitation in that an effect thereof is limited in an area in which external air has a relatively high temperature (for example, about 50°C).

Thus, to solve the above-described limitation, a technology in which a cooling device for allowing a refrigerant within the refrigeration cycle to flow is provided at a side of the electronic unit to heat-exchange a refrigerant with the electronic unit, thereby cooling the electronic unit is being introduced in recent years. For example, the cooling device may include a refrigerant tube.

The cooling device may be maintained in a state where it is coupled to the electronic unit. If repairing of the electronic unit or replacement of the control components is needed, the cooling device or the refrigerant tube has to be removed. Then, after the repairing or replacement is finished, the cooling device or the refrigerant tube has to be assembled again, and then a refrigerant has to be recharged.

### SUMMARY

The invention is specified in the claims. Embodiments provide an air conditioner that is capable of efficiently cooling an electronic unit.

In one embodiment, an air conditioner includes: an electronic unit including a control component for driving a refrigerant cycle; and a cooling tube through which a refrigerant for cooling the electronic unit flows, the cooling tube being coupled to one side of the electronic unit, wherein the electronic unit includes: an electronic case having a through part; an electronic board to which the control component is coupled, the electronic board being disposed in the electronic case; a heat transfer plate disposed to contact the control component, the heat transfer plate being coupled to the electronic case; and a heat-sink plate to which the cooling tube is coupled, the heat-sink plate contacting the heat transfer plate through the through part.

The heat transfer plate may be supported by an inner surface of the electronic case, and the heat-sink plate may be supported by an outer surface of the electronic case.

The control component may be disposed between the electronic board and the heat transfer plate.

The electronic board further includes a fixing guide that is spaced apart from the heat transfer plate and disposed on the same side of the heat transfer plate but spaced apart from each other at opposite ends or edges of the heat transfer plate.

The fixing guide may include: a first guide part coupled to the electronic board; and a second guide part bent to extend from the first guide part, the second guide part being coupled to the heat transfer plate.

The air conditioner may further include a spacer coupled between the first guide part of the fixing guide and the electronic board.

The air conditioner may further include a plurality of coupling guides disposed in the electronic case to guide the heat transfer plate so that the heat transfer plate is coupled to the inner surface of the electronic case.

The heat transfer plate may be separably coupled in a space between the plurality of coupling guides.

The air conditioner further includes a first coupling member passing through the fixing guide and the heat transfer plate so as to couple them to the electronic case.

The air conditioner may further include a second coupling member for coupling the heat-sink plate to the electronic case, wherein the second coupling member may pass through the heat-sink plate and be coupled to the heat transfer plate.

The through part may include a first through part and a second through part, and the heat-sink pate may include first and second heat-sink plates that are respectively coupled to the first and second through parts.

The cooling tube may include: a first cooling tube guiding a flow of the refrigerant in one direction; a second cooling tube guiding the flow of the refrigerant in the other direction; and a switching tube rounded or bent between the first cooling tube and the second cooling tube, wherein the refrigerant may successively flow into the first cooling tube, the switching tube, and the second cooling tube.

The air conditioner may further include an insertion part, which is formed by recessing at least one of the heat-sink plate, in which the first or second cooling tube is placed.

The air conditioner may further include: an outdoor heat exchanger in which outdoor air and the refrigerant are heat-exchanged with each other; and a main expansion valve through which the refrigerant condensed in the outdoor heat exchanger passes, the main expansion valve being disposed on one side of the outdoor heat exchanger, wherein the cooling tube may guide the refrigerant passing through the main expansion valve to a refrigerant passage of the heat-sink plate.

The air conditioner may further include: a supercooling heat exchanger in which the refrigerant passing through the heat-sink plate is introduced; and a supercooling distributor disposed on an inlet-side of the supercooling heat exchanger to branch the refrigerant.

The details of one or more embodiments are set forth in the accompanying drawings and the description below. Other advantages will be apparent from the description and drawings, and from the claims.

### BRIEF DESCRIPTION OF THE DRAWINGS

Fig. 1 is a perspective view of an exterior of an outdoor unit according to an embodiment.
Fig. 2 is a perspective view illustrating internal constitutions of the outdoor unit according to an embodiment.
Fig. 3 is a system view illustrating constitutions of the outdoor unit according an embodiment.
Fig. 4 is a perspective view illustrating a portion of the electronic unit according to an embodiment.
Fig. 5 is a perspective view illustrating constitutions of an electronic case according to an embodiment.
Fig. 6 is a cross-sectional view taken along line I-I' of Fig. 4.

### DETAILED DESCRIPTION OF THE EMBODIMENTS

Hereinafter, exemplary embodiments will be described with reference to the accompanying drawings. The invention may, however, be embodied in many different forms and should not be construed as being limited to the embodiments set forth herein; rather, the invention is solely limited by the appended claims.

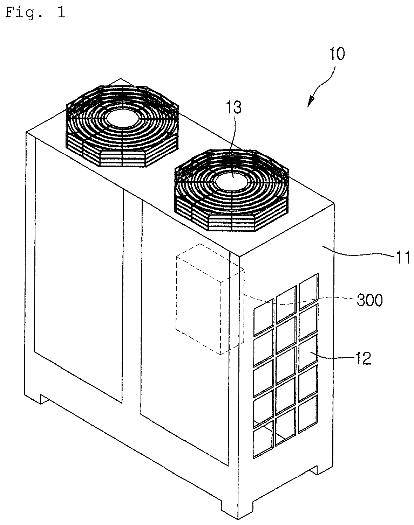

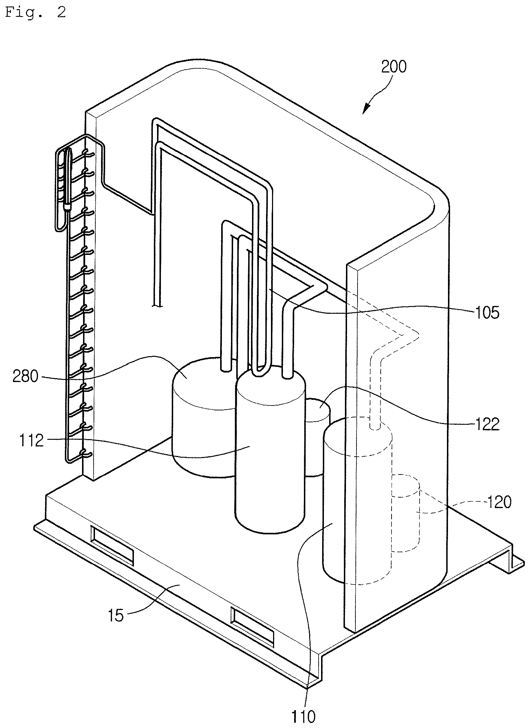

Fig. 1 is a view of an exterior of an outdoor unit according to an embodiment, and Fig. 2 is a perspective view illustrating internal constitutions of the outdoor unit according to an embodiment.

Referring to Figs. 1 and 2, an air conditioner according to an embodiment includes an outdoor unit 10 heat-exchanging with outdoor air and an indoor unit (not shown) disposed in an indoor space to condition indoor air.

The outdoor unit 10 includes a case 11 defining an outer appearance thereof and including a plurality of built-in components. The case 11 includes a suction part 12 for sucking the outdoor air and a discharge part 13 for discharging the sucked air after the sucked air is heat-exchanged. For example, the suction part 12 may be disposed in a side surface of the case 11, and the discharge part 13 may be disposed in a top surface of the case 11.

The case 11 includes a plurality of compressors 110 and 112 for compressing a refrigerant, a gas/liquid separator 280 for filtering a liquid refrigerant from the refrigerant sucked into the plurality of compressors 110 and 112, oil separators 120 and 122 respectively coupled to sides of the plurality of compressors 110 and 112 to separate an oil from the refrigerant discharged from the compressors 110 and 112, and an outdoor heat exchanger 200 heat-exchanged with the outdoor air.

The plurality of compressors 110 and 112, the gas/liquid separator 280, and the outdoor heat exchanger 200 may be disposed on a base 15 of the outdoor unit 10. The base 15 may define a bottom surface of the outdoor unit 10.

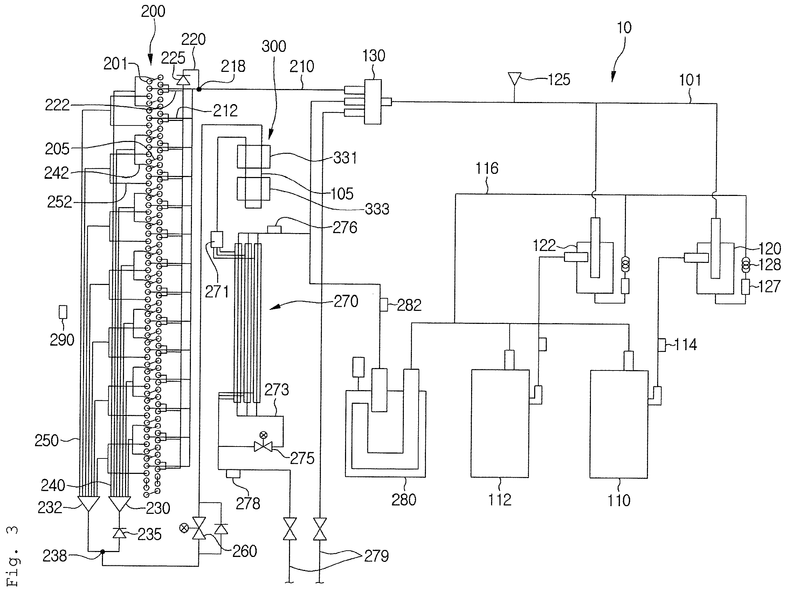

The outdoor unit 10 may further include a refrigerant tube 101 (see Fig. 3) for guiding the refrigerant circulated into the outdoor unit 10, i.e., the refrigerant flowing into the plurality of compressors 110 and 112, the gas/liquid separator 280, and the outdoor heat exchanger 200.

The refrigerant tube 101 includes a cooling tube 105 coupled to a side of the electronic case 301 to cool the electronic unit 300. The electronic unit 300 may be separably coupled to an inner surface of the case 11 of the outdoor unit 10. The constitutions of the electronic unit 300 will be described with reference to the accompanying drawings.

Fig. 3 is a system view illustrating constitutions of the outdoor unit according an embodiment.

Referring to Fig. 3, the outdoor unit 10 of the air conditioner according to an embodiment includes the plurality of compressors 110 and 112 and the oil separators 120 and 122 disposed on outlet-sides of the plurality of compressors 110 and 112 to separate the oil from the refrigerant discharged from the plurality of compressors 110 and 112.

The plurality of compressors 110 and 112 include a first compressor 110 and a second compressor 112, which are connected in parallel to each other. A discharge temperature sensor 114 for detecting a temperature of the compressed refrigerant may be disposed on an outlet-side of each of the first and second compressors 110 and 112.

Also, the oil separators 120 and 122 include a first oil separator 120 disposed on the outlet-side of the first compressor 110 and a second oil separator 122 disposed on the outlet-side of the second compressor 112.

The air conditioner 10 includes a collection passage 116 for collecting the oil from the oil separators 120 and 122 into the compressors 110 and 112. The collection passage 116 may extend from each of the outlet-sides of the first and second oil separators 120 and then combined with each other. Here, the combined passage may be connected to the inlet-side tube of each of the first and second compressors 110 and 112.

A high-pressure sensor 125 for detecting a discharge pressure of the refrigerant discharged from the compressors 110 and 112 and a flow switching part 130 for guiding the refrigerant passing through the high-pressure sensor 125 to the outdoor heat exchanger 200 or the indoor unit are disposed on the outlet-sides of the oil separators 120 and 122. For example, the flow switching part 130 may include a four-way valve.

When the air conditioner operates in a cooling mode, the refrigerant may be introduced from the flow switching part 130 into the outdoor heat exchanger 200. On the other hand, when the air conditioner operates in a heating mode, the refrigerant may flow from the flow switching part 130 into an indoor heat exchange-side of the indoor unit (not shown).

When the air conditioner operates in the cooling mode, the refrigerant condensed in the outdoor heat exchanger 200 passes through a main expansion valve 260 (electric expansion valve) that is provided in the outlet-side of the outdoor heat exchanger 200. When the cooling operation is performed, the main expansion valve 260 may be fully opened and thus may not perform decompression of the refrigerant.

The refrigerant passing through the main expansion valve 260 may pass through heat-sink plates 331 and 333 along the cooling tube 105. That is, when the cooling operation is performed, the cooling tube 105 may be disposed on the outlet-side of the main expansion valve 260.

The heat-sink plates 331 and 333 may be disposed on the electronic unit 300 including a heat generation component, and the cooling tube 105 may be coupled to the heat-sink plates 331 and 333. The refrigerant flowing into the cooling tube 105 cools the heat generation component.

The outdoor unit 10 further includes a supercooling heat exchanger 270 in which the refrigerant passing through the heat-sink plates 331 and 333 is introduced and a supercooling distributor 271 is disposed on an inlet-side of the supercooling heat exchanger 270 to branch the refrigerant. The supercooling heat exchanger 270 may serve as an intermediate heat exchanger in which a first refrigerant circulated into the system and a portion (a second refrigerant) of the first refrigerant are heat-exchanged with each other after the refrigerant is branched.

Here, the first refrigerant may be a refrigerant that is introduced into the supercooling heat exchanger 270 via the supercooling distributor 271 and thus be supercooled by the second refrigerant. On the other hand, the second refrigerant may absorb heat from the first refrigerant.

The outdoor unit 10 may includes a supercooling passage 273 disposed on an outlet-side of the supercooling heat exchanger 270 to branch the second refrigerant from the first refrigerant. Also, a supercooling expansion device 275 for decompressing the second refrigerant may be disposed in the supercooling passage 273. The supercooling expansion device 275 may include the electric expansion valve (EEV).

The second refrigerant of the supercooling passage 273 may be introduced into the supercooling heat exchanger 270 and then be heat-exchanged with the first refrigerant to flow toward an inlet-side of the gas/liquid separator 280. The air conditioner 10 further includes a supercooling discharge temperature sensor 276 for detecting a temperature of the second refrigerant passing through the supercooling heat exchanger 270.

The gas/liquid separator 280 may be configured to separate a gaseous refrigerant from the refrigerant before the refrigerant is introduced into the compressors 110 and 112. The separated gaseous refrigerant may be introduced into the compressors 110 and 112.

While the refrigeration cycle is driven, the evaporation refrigerant may be introduced into the gas/liquid separator 280 via the flow switching part 130. Here, the evaporation refrigerant may be mixed with the second refrigerant passing through the supercooling heat exchanger 270 and then be introduced into the gas/liquid separator 280.

A suction temperature sensor 282 for detecting a temperature of the refrigerant to be sucked into the compressors 110 and 112 may be disposed on the inlet-side of the gas/liquid separator 280.

The first refrigerant passing through the supercooling heat exchanger 270 may be introduced into the indoor unit through an indoor unit connection tube 279. The outdoor unit 10 further includes a liquid tube temperature sensor 278 disposed on the outlet-side of the supercooling heat exchanger 270 to detect a temperature of the first refrigerant passing through the supercooling heat exchanger 270, i.e., a temperature of the supercooled refrigerant.

The outdoor heat exchanger 200 includes a heat exchange tube 201 having a plurality of rows and stages. For example, the heat exchange tube 201 may be provided in plurality so that the plurality of heat exchange tubes 201 are arranged in two rows in a horizontal direction and stepped in plural stages in a vertical direction.

The outdoor heat exchanger 200 further include a return tube 205 coupled to ends of the plurality of heat exchange tubes 201 to guide the refrigerant flowing into one heat exchange tube 201 toward the other heat exchange tube 201. The return tube 205 may be provided in plurality.

The air conditioner 10 further includes a first connection tube 210 extending from the flow switching part 130 to a tube part (hereinafter, referred to as a first row tube part) constituting one row of the plurality of heat exchange tubes 201. Also, the first connection tube 210 includes a plurality of first branch tubes 212 for branching the refrigerant into the plurality of refrigerant tubes constituting the first row tube part.

The air conditioner 10 further includes a second connection tube 220 branched from the first connection tube 210 to extend to a tube part (hereinafter, referred to as a second row tube part) constituting the other row of the plurality of heat exchange tubes 201. Also, the second connection tube 220 includes a plurality of second branch tubes 222 that branches the refrigerant into the plurality of refrigerant tubes constituting the second row tube part to allow the branched refrigerants into the plurality of refrigerant tubes.

A first branch part 218 is disposed in the first connection tube 210. The second connection tube 220 may be branched from the first connection tube 210 at the first branch part 218. A first check valve 225 that is a "valve member" for guiding a flow of the refrigerant in one direction may be disposed in the second connection tube 220.

Here, the "one direction" may be understood as a direction in which the refrigerant flows from the second connection tube 220 to the first connection tube 210. Thus, when the air conditioner 10 operates in the cooling mode, the refrigerant flowing into the first connection tube 210 may be limited in flow in a direction of the second connection tube 220 through the first branch part 218.

The outdoor unit 10 further includes a plurality of distribution devices 230 and 232 for branching and introducing the refrigerant into the outdoor heat exchanger 200 when the heating operation is performed.

The plurality of distribution devices 230 and 232 include a first distribution device 230 for branching the refrigerant into the plurality of return tubes 205 and a second distribution device 232 for branching the refrigerant portions of the plurality of heat exchange tubes 201.

Also, the outdoor unit 10 further includes a second branch part 238 for distributing the refrigerant into the first and second distribution devices 230 and 232.

When the air conditioner 10 operates in the heating mode, the refrigerant may be distributed into the first and second distribution devices 230 and 232 via the second branch part 238 and then be introduced into the outdoor heat exchanger 200.

The outdoor unit 10 further includes a plurality of third connection tubes 240 extending from the first distribution device 230 to the return tube 205. Also, the third connection tube 240 includes a plurality of third branch tubes 242 coupled to the plurality of return tubes 205 to branch the refrigerant into the plurality of return tubes 205.

The outdoor unit 10 further includes a plurality of fourth connection tubes 250 extending from the second distribution device 232 to portions of the plurality of heat exchange tubes 201. Also, the fourth connection tube 250 includes a plurality of fourth branch tubes 252 for branching the refrigerant.

The outdoor unit 10 further includes a second check valve 235 that is a "valve member" for guiding a flow of the refrigerant in one direction and is disposed on a side of the outdoor heat exchanger 200. The second check valve 235 may be disposed on an inlet-side of the first distribution device 230 when the heating operation is performed.

The "one direction" may be understood as a direction in which the refrigerant flows from the first distribution device 230 to the third connection tube 240 or the third branch tube 242. Thus, the introduction of the refrigerant, which flows into the third connection tube 240 or the third branch tube 242, into the first distribution device 230 may be limited by the second check valve 235.

The air conditioner 10 further includes an outdoor temperature sensor 290 disposed in the outdoor unit to detect a temperature of external air.

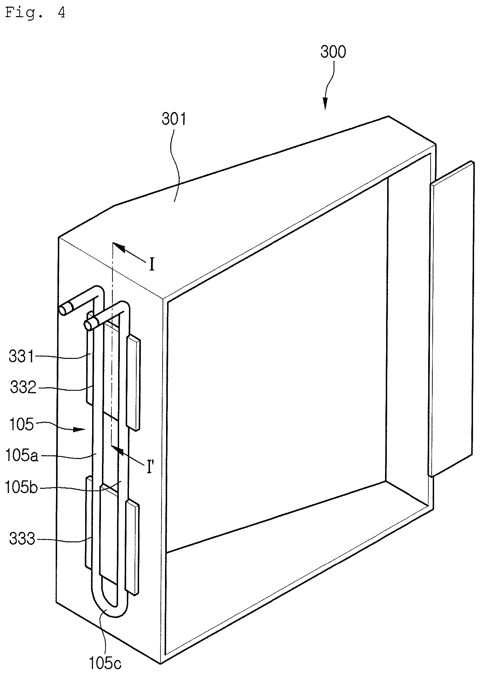

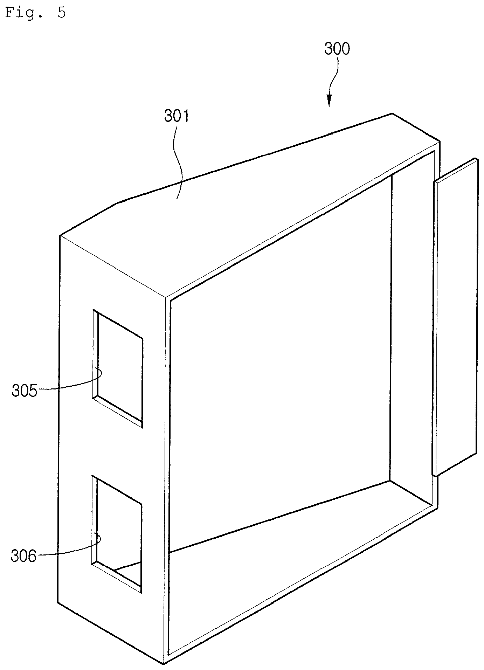

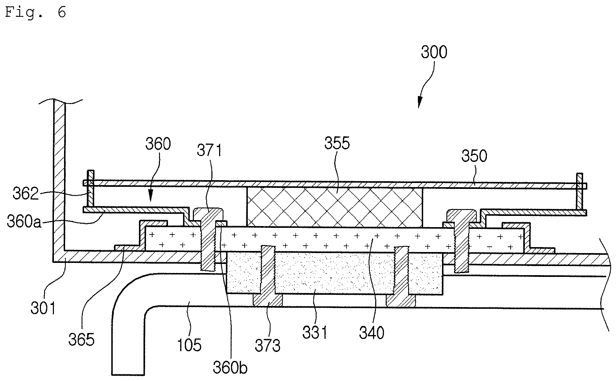

Fig. 4 is a perspective view illustrating a portion of the electronic unit 300 according to an embodiment, Fig. 5 is a perspective view illustrating constitutions of an electronic case according to an embodiment, and Fig. 6 is a cross-sectional view taken along line I-I' of Fig. 4.

Referring to Figs. 4 and 5, an electronic unit 300 according to an embodiment includes an electronic case 301 defining a predetermined inner space therein. An electronic board 350 and a plurality of control components disposed on the electronic board 350 are disposed within the electronic case 301. The plurality of control components include a heat generation component 355 for generating high-temperature heat.

For example, the heat generation component 355 may include a power module (e.g., an intelligent power module (IPM)). The IPM may be understood as a driving circuit of a power device such as a power MOSFET or IGBT and a protection circuit having a self protection function. The power module may be called a "power device". Also, the electronic board 350 may be a portion of the IPM.

When the power module is driven, a switching device provided in the power module may be turned on or off to generate heat having a temperature of about 70°C to about 80°C.

In addition, the heat generation component may include a micron computer, an inverter, a converter, an EEPROM, a rectifier diode, or a condenser. The heat generation component may be disposed within the electronic case 301.

The plurality of heat-sink plates 331 and 333 for cooling the electronic unit 300 may be separably coupled to the electronic unit 300. The plurality of heat-sink plates 331 and 333 include first and second heat-sink plates 331 and 333 which are spaced apart from one side surface of the electronic case 301.

A plurality of heat-sink plate coupling parts 305 and 306 to which the plurality of heat-sink plates 331 and 333 are coupled are disposed in the electronic case 301. The plurality of heat-sink plate coupling parts 305 and 306 may pass between the inside and the outside of the electronic case 301. The heat-sink plate coupling parts 305 and 306 may be called "through parts".

The heat-sink coupling parts 305 and 306 include a first heat-sink plate coupling part 305 coupled to the first heat-sink plate 331 and a second heat-sink plate coupling part 306 coupled to the second heat-sink plate 333.

Each of the first and second heat-sink plates 331 and 333 may be formed of a metal having superior thermal conductivity or thermal conductive plastic. The thermal conductive plastic may be understood as a material having properties of plastic, i.e., a small weight, a free design, and a low thermal expansion coefficient and heat transfer properties of metal and ceramic. For example, each of the plurality of heat-sink plates 331 and 333 may include aluminum as the metal material.

For another example, each of the plurality of heat-sink plates 331 and 333 may include polyethylene (-[CH₂CH₂]n-) in which ethylene is polymerized and carbon nanotube (CNT) as the thermal conductive plastic. The thermal conductive plastic may have thermal conductivity greater by about 100 times than that of general plastic.

At least one portion of the first and second heat-sink plates 331 and 333 may be inserted into the heat-sink plate coupling parts 305 and 306, respectively.

Also, the first and second heat-sink plates 331 and 333 may be coupled to contact a heat transfer plate 340 through the first and second heat-sink plate coupling parts 305 and 306. That is, the first and second heat-sink plate coupling parts 305 and 306 may provide spaces in which the first and second heat-sink plates 331 and 333 are coupled to the heat transfer plate 340.

An insertion part 332 in which the cooling tube 105 is placed may be defined in each of the first and second heat-sink plates 331 and 333. The insertion part 332 may be formed by recessing at least one portion of each of the first and second heat-sink plates 331 and 333. Also, the insertion part 332 may be provided in plurality. Also, the cooling tube 105 may be a bent or curved shape so that the cooling tube 105 is coupled to the plurality of insertion parts 332. The insertion part 332 may be called a "refrigerant passage" in that the insertion part 332 provides a passage through which the refrigerant flows.

In detail, the cooling tube 105 includes a first cooling tube 105a for guiding a flow of the refrigerant in one direction and a second cooling tube 105b for guiding a flow of the refrigerant in the other direction.

Also, the cooling tube 105 further include a switching tube 105c coupled between the first cooling tube 105a and the second cooling tube 105b. The switching tube 105c may be rounded or bent to switch a flow direction of the refrigerant.

For example, when the air conditioner operates in the cooling mode, the refrigerant flowing into the first heat-sink plate 331 through the first cooling tube 105a may flow into the second heat-sink plate 333 to perform cooling.

Also, the refrigerant may be introduced into the second cooling tube 105b via the switching tube 105c to successively pass through the second heat-sink plate 333 and the first heat-sink plate 331. In this process, the refrigerant may perform the cooling again.

As described above, the refrigerant that performs the cooling two times may flow toward the supercooling distributor 271. Heat generated in the electronic unit 300 may have a temperature of about 70°C to about 80°C. Also, since the refrigerant passing through the outdoor heat exchanger 200 and the main expansion valve 260 has a temperature of about 30°C, the refrigerant may effectively cool the electronic unit 300.

Referring to Fig. 6, a electronic board 350, a heat generation component 355 coupled to the electronic board 350 to generate predetermined heat, and a heat transfer plate 340 disposed to contact the heat generation component 355, thereby transferring the heat of the heat generation component 355 to the outside of the electronic case 301.

The heat transfer plate 340 may be approximately closely attached to an inner surface of the electronic case 301. The heat transfer plate 340 has one side surface that contacts the heat generation component 355 and the other side surface that contacts the first and second heat-sink plates 331 and 333 through the first and second heat-sink plate coupling parts 305 and 306. In a state where the first and second heat-sink plates 331 and 333 are separated from the electronic case 301, when viewed from the outside of the electronic case 301, the heat transfer plate 340 may be seen through the first and second heat-sink plate coupling parts 305 and 306.

The heat generation component 355 and the heat transfer plate 340 may be disposed between the inner surface of the electronic case 301 and the electronic board 350. That is, the electronic board 350 may be disposed at a position that is spaced apart from the heat transfer plate 340. Also, the heat generation component 355 may be disposed between the electronic board 350 and the heat transfer plate 340.

The electronic unit 300 further includes a fixing guide 360 for fixing the electronic board 350 at a position that is spaced apart from the heat transfer plate 340. The fixing guide 360 may be coupled to the electronic board 350 and the heat transfer plate 340 and be disposed on the same side of the heat transfer plate 340 or of the electronic board 350 but being spaced from each other at opposite ends of the heat transfer plate 340 or of the electronic board 350.

In detail, the fixing guide 360 includes a first guide part 360a coupled to the electronic board 350 by a fixing device 362 and a second guide part 360b bent to extend from the first guide part 360a and coupled to the heat transfer plate 340 by the first coupling member 371.

The fixing device 362 may be a device for fixing the first guide part 360a and the electronic board 350 in a state where the first guide part 360a and the electronic board 350 are spaced apart from each other. Thus, the fixing device 362 may be called a spacer. The fixing device 362 may be separably coupled between the electronic board 350 and the first guide part 360a of the fixing guide 360.

Thus, the electronic board 350 may be easily fixed to the heat transfer plate 340 by the fixing guide 360 in the state where the electronic board 350 is spaced apart from the heat transfer plate 340.

The first coupling member 371 may be understood as a coupling member for coupling the fixing guide 360 and the heat transfer plate 340 to the electronic case 301. In detail, the first coupling member 371 may pass through the fixing guide 360 and the heat transfer plate 340 and then be coupled to the electronic case 301.

That is, the fixing guide 360, the heat transfer plate 340, and the electronic case 301 may be coupled at the same time by the first coupling member 371. For example, the first coupling member 371 may include a screw member.

A coupling guide 365 for guiding the coupling of the heat transfer plate 340 may be disposed on the inner surface of the electronic case 301. The coupling guide 365 may be disposed on each of both sides of the heat transfer plate 340 to support the heat transfer plate 340.

The coupling guide 365 may have a bent shape. Also, at least one portion of the coupling guide 365 may be coupled to the inner surface of the electronic case 301, and the rest portion of the coupling guide 365 may be coupled to a side surface part of the heat transfer plate 340.

The heat transfer plate 340 may be separably inserted into an inner space defined by the two coupling guides 365. For example, the heat transfer plate 340 may be slidably coupled to or separated from the inner space of the two coupling guides 365.

The heat transfer plate 340 may be supported by the coupling guides 365. Thus, it may prevent the heat transfer plate 340 from being separated toward the inside of the electronic case 301.

The first and second heat-sink plates 331 and 333 disposed to contact the heat transfer plate 340, thereby transferring heat of the heat generation component 355 into the cooling tube 105 may be provided outside the electronic case 301. That is, the first and second heat-sink plates 331 and 333 may be supported by an outer surface of the electronic case 301.

Since the first and second heat-sink plates 331 and 333 have the same coupling structure, the first heat-sink plate 331 will be described as an example.

The first heat-sink plate 331 may be inserted into the first heat-sink plate coupling part 305 to contact one surface of the heat transfer plate 340. Here, the heat transfer plate 340 may be closely attached to the inner surface of the electronic case 301 and may not protrude outward from the first heat-sink plate coupling part 305. Also, both sides of the heat transfer plate 340 may be supported by the inner surface of the electronic case 301. That is, the constitutions disposed outside the electronic case 301 may be limited by the first heat-sink plate 331.

The first heat-sink plate 331 and the heat transfer plate 340 may be coupled to each other by a second coupling member 373. The second coupling member 373 may be understood as a coupling member for coupling the first heat-sink plate 331 to the electronic case 301.

The second coupling member 373 may pass through the first heat-sink plate 331 and then be coupled to the heat transfer plate 340. For example, the second coupling member 373 may include a screw member.

When the second coupling member 373 is removed, the first heat-sink plate 331 may be separated from the heat transfer plate 340. That is, the first heat-sink plate 331 may be separated from the electronic case 301.

If it is intended to separate the cooling tube 105 to perform after-sales service (repairing or replacement) for the electronic unit 300 or the cooling tube 105, when the second coupling member 373 is removed, the electronic case 301 may be separated from the first heat-sink plate 331. Thus, only the electronic case 301 may be easily separated to perform the after-sales service.

Also, when the after-sales service for the electronic case 301 is finished, the first heat-sink plate 331 and the heat transfer plate 340 may be coupled to each other by using the second coupling member 373 to easily assemble the electronic unit 300.

Also, according to the above-described constitutions, the cooling device of the electronic unit 300 may be manufactured by using only a relatively small number of coupling members.

A cooling operation of the electronic unit 300 will now be simply described.

When the outdoor unit 10 operates, high-temperature heat may be generated by the operation of the heat generation component 355 such as the power module. The generated heat may be transferred to the first and second heat-sink plates 331 and 333 through the heat transfer plate 340.

Since each of the first and second heat-sink plates 331 and 333 is formed of aluminum or conductive plastic having superior thermal conductivity, the heat generated in the heat generation component may be quickly absorbed. Thus, the heat-sink plates 310 and 320 may increase in temperature.

While the air conditioner operates, the refrigerant cycle may be driven. The refrigerant condensed in the outdoor heat exchanger 200 may pass through the main expansion valve 260 to flow along the cooling tube 105 and then be introduced into the first and second heat-sink plates 331 and 333.

While the refrigerant having a relatively low temperature passes through the first and second heat-sink plates 331 and 333, the first and second heat-sink plates 331 and 333 may be quickly cooled. That is, the cooling of the first and second heat-sink plates 331 and 333 may be effectively performed by a temperature difference between the refrigerant having a temperature of about 30°C and the heat-sink plates 331 and 333 having a temperature of about 70°C to about 80°C.

The refrigerant discharged from the first and second heat-sink plates 331 and 333 may be introduced into the supercooling heat exchanger 270 through the supercooling distributor 271.

Hereinafter, a manipulation method when the electronic unit or the cooling tube 105 is repaired or replaced will be simply described.

As described above, the first and second heat-sink plates 331 and 333 may be separably coupled to the electronic case 301 by the second coupling member 373.

When the second coupling member 373 is released to separate the first and second heat-sink plates 331 and 333 from the heat transfer plate 340, the first and second heat-sink plates 331 and 333 may be separated from the electronic case 301. That is, the cooling tube 105 coupled to the first and second heat-sink plates 331 and 333 may be separated from the electronic case 301 without performing the other manipulation operation. Thus, the after-sales service with respect to the separated cooling tube 105 or the electronic case 301 may be easily performed.

When the after-sales service with respect to the electronic unit 300 or the cooling tube 105 is finished, the cooling tube 105 and the first and second heat-sink plates 331 and 333 may be easily assembled with each other in reverse order of the above-described order.

According to the proposed embodiment, since the electronic unit is cooled by using the refrigerant heat circulated into the refrigeration cycle, it may prevent the control components provided in the electronic unit from malfunctioning and also prevent the air conditioner from being broken down.

Also, the electronic board on which the heat generation component is disposed and the heat transfer plate may be disposed inside the electronic case, and the heat-sink plate contacting the heat transfer plate and the cooling tube may be disposed outside the electronic case. Thus, when the electronic case is separated from the cooling tube, only the heat-sink plate may be easily separated to easily perform the after-sales service with respect to the electronic unit or the cooling tube.

Also, since the fixing guide extending from the electronic board to the heat transfer plate to fix the electronic board to the heat transfer plate, it may prevent the electronic board from being separated or broken down by the vibration occurring when the outdoor unit operates.

Also, the plurality of coupling guides are provided on the inner surface of the electronic case to guide the coupling of the heat transfer plate, the heat transfer plate may be easily coupled to the electronic case. In addition, the heat transfer plate may be fixed in position in the state where the heat transfer plate is coupled to the electronic case.

Also, the electronic case, the heat transfer plate, and the fixing guide may be coupled to each other by using one coupling member. Thus, when the electronic board is separated from the electronic case, only one coupling member may be separated to easily perform the after-sales service with respect to the electronic unit.

## Claims

1. An air conditioner comprising:
an electronic unit (300) comprising a control component (355) for driving a refrigerant cycle; and
a cooling tube (105) through which a refrigerant for cooling the electronic unit (300) flows, the cooling tube (105) being coupled to one side of the electronic unit (300),
wherein the electronic unit (300) comprises:
an electronic case (301) having a through part (305, 306) ;
an electronic board (350) to which the control component (355) is coupled, the electronic board (350) being disposed within the electronic case (301);
a heat transfer plate (340) disposed to contact the control component, the heat transfer plate (340) being coupled to the electronic case (301);
a heat-sink plate (331, 333) to which the cooling tube (105) is coupled, the heat-sink plate (331, 333) contacting the heat transfer plate (340) through the through part (305, 306) ;
fixing guides (360) spacing the electronic board (350) apart from the heat transfer plate (340), being disposed on the same side of the heat transfer plate (340) but spaced from each other at opposite ends; **characterised by**
first coupling members (371) configured to couple the fixing guides (360) and the heat transfer plate (340) to the inner surface of the electronic case (301),
wherein the first coupling members (371) pass through the respective fixing guide (360) and the heat transfer plate (340) so as to couple them to the electronic case (301).

2. The air conditioner according to claim 1, wherein the heat transfer plate (340) is supported by an inner surface of the electronic case (301).

3. The air conditioner according to claim 1 or 2, wherein the control component is disposed between the electronic board (350) and the heat transfer plate (340).

4. The air conditioner according to any of claims 1 to 3, wherein each of the fixing guides (360) comprises:
a first guide part (360a) coupled to the electronic board (350); and
a second guide part (360b) bent to extend from the first guide part (360a), the second guide part (360b) being coupled to the heat transfer plate (340).

5. The air conditioner according to claim 4, further comprising spacers (362) coupled between the respective first guide part (360a) of the fixing guides (360) and the electronic board (350).

6. The air conditioner according to any one of claims 1 to 5, further comprising a plurality of coupling guides (365) disposed within the electronic case (301) to support the heat transfer plate (340) such that the heat transfer plate (340) is coupled to the inner surface of the electronic case (301).

7. The air conditioner according to claim 6, wherein the heat transfer plate (340) is separably coupled in a space between the plurality of coupling guides (365).

8. The air conditioner according to any one of claims 1 to 7, further comprising a second coupling member (373) for coupling the heat-sink plate (331, 333) to the electronic case (301),
wherein the second coupling member (373) passes through the heat-sink plate (331, 333) and is coupled to the heat transfer plate (340).

9. The air conditioner according to any one of claims 1 to 8, wherein the through part (305, 306) comprises a first through part (305) and a second through part (306), and
the heat-sink pate (331, 333) comprises first (331) and second (333) heat-sink plates that are respectively coupled to the first and second through parts.

10. The air conditioner according to any one of claims 1 to 9, wherein the cooling tube (105) comprises:
a first cooling tube (105a) guiding a flow of the refrigerant in one direction;
a second cooling tube (105b) guiding the flow of the refrigerant in another direction; and
a switching tube (105c) rounded or bent between the first cooling tube (105a) and the second cooling tube (105b),
wherein the refrigerant successively flows into the first cooling tube (105a), the switching tube (105c), and the second cooling tube (105b).

11. The air conditioner according to claim 10, further comprising an insertion part (332), which is formed by recessing at least one of the heat-sink plate (331, 333), in which the first (105a) or second cooling tube (105b) is placed.

12. The air conditioner according to any one of claims 1 to 11, further comprising:
an outdoor heat exchanger (200) in which outdoor air and the refrigerant are heat-exchanged with each other; and
a main expansion valve (260) through which the refrigerant condensed in the outdoor heat exchanger (200) passes, the main expansion valve (260) being disposed on one side of the outdoor heat exchanger (200),
wherein the cooling tube (105) guides the refrigerant passing through the main expansion valve (260) to a refrigerant passage of the heat-sink plate (331, 333).

13. The air conditioner according to any one of claims 1 to 12, further comprising:
a supercooling heat exchanger (270) in which the refrigerant passing through the heat-sink plate (331, 333) is introduced; and
a supercooling distributor (271) disposed on an inlet-side of the supercooling heat exchanger (270) to branch the refrigerant.

## Patentansprüche

1. Klimaanlage, die aufweist:
eine Elektronikeinheit (300) mit einer Steuerkomponente (355) zum Ansteuern eines Kältemittelkreislaufs; und
ein Kühlrohr (105), durch das ein Kältemittel zum Kühlen der Elektronikeinheit (300) strömt, wobei das Kühlrohr (105) mit einer Seite der Elektronikeinheit (300) gekoppelt ist,
wobei die Elektronikeinheit (300) aufweist:
ein Elektronikgehäuse (301) mit einem Durchgangsteil (305, 306);
eine Elektronikplatine (350), mit der die Steuerkomponente (355) gekoppelt ist, wobei die Elektronikplatine (350) im Elektronikgehäuse (301) angeordnet ist;
eine Wärmeübertragungsplatte (340), die so angeordnet ist, dass sie die Steuerkomponente kontaktiert, wobei die Wärmeübertragungsplatte (340) mit dem Elektronikgehäuse (301) gekoppelt ist;
eine Wärmeableitplatte (331, 333), mit der das Kühlrohr (105) gekoppelt ist, wobei die Wärmeableitplatte (331, 333) die Wärmeübertragungsplatte (340) durch das Durchgangsteil (305, 306) hindurch kontaktiert;
Fixierführungen (360), die die Elektronikplatine (350) von der Wärmeübertragungsplatte (340) beabstanden und auf derselben Seite der Wärmeübertragungsplatte (340), aber an entgegengesetzten Enden voneinander beabstandet angeordnet sind; **gekennzeichnet durch**
erste Koppelbauteile (371), die so konfiguriert sind, dass sie die Fixierführungen (360) und die Wärmeübertragungsplatte (340) mit der Innenfläche des Elektronikgehäuses (301) koppeln,
wobei die ersten Koppelbauteile (371) die jeweilige Fixierführung (360) und die Wärmeübertragungsplatte (340) durchlaufen, um sie mit dem Elektronikgehäuse (301) zu koppeln.

2. Klimaanlage nach Anspruch 1, wobei die Wärmeübertragungsplatte (340) durch eine Innenfläche des Elektronikgehäuses (301) gestützt wird.

3. Klimaanlage nach Anspruch 1 oder 2, wobei die Steuerkomponente zwischen der Elektronikplatine (350) und der Wärmeübertragungsplatte (340) angeordnet ist.

4. Klimaanlage nach einem der Ansprüche 1 bis 3, wobei jede der Fixierführungen (360) aufweist:
ein erstes Führungsteil (360a), das mit der Elektronikplatine (350) gekoppelt ist; und
ein zweites Führungsteil (360b), das so abgebogen ist, dass es sich vom ersten Führungsteil (360a) erstreckt, wobei das zweite Führungsteil (360b) mit der Wärmeübertragungsplatte (340) gekoppelt ist.

5. Klimaanlage nach Anspruch 4, ferner mit Abstandshaltern (362), die zwischen dem jeweiligen ersten Führungsteil (360a) der Fixierführungen (360) und der Elektronikplatine (350) gekoppelt sind.

6. Klimaanlage nach einem der Ansprüche 1 bis 5, ferner mit mehreren Koppelführungen (365), die im Elektronikgehäuse (301) angeordnet sind, um die Wärmeübertragungsplatte (340) so zu stützen, dass die Wärmeübertragungsplatte (340) mit der Innenfläche des Elektronikgehäuses (301) gekoppelt ist.

7. Klimaanlage nach Anspruch 6, wobei die Wärmeübertragungsplatte (340) in einem Raum zwischen den mehreren Koppelführungen (365) trennbar gekoppelt ist.

8. Klimaanlage nach einem der Ansprüche 1 bis 7, ferner mit einem zweiten Koppelbauteil (373) zum Koppeln der Wärmeableitplatte (331, 333) mit dem Elektronikgehäuse (301),
wobei das zweite Koppelbauteil (373) die Wärmeableitplatte (331, 333) durchläuft und mit der Wärmeübertragungsplatte (340) gekoppelt ist.

9. Klimaanlage nach einem der Ansprüche 1 bis 8, wobei das Durchgangsteil (305, 306) ein erstes Durchgangsteil (305) und ein zweites Durchgangsteil (306) aufweist und
die Wärmeableitplatte (331, 333) eine erste (331) und zweite (333) Wärmeableitplatte aufweist, die mit dem ersten bzw. zweiten Durchgangsteil gekoppelt sind.

10. Klimaanlage nach einem der Ansprüche 1 bis 9, wobei das Kühlrohr (105) aufweist:
ein erstes Kühlrohr (105a), das eine Strömung des Kältemittels in einer Richtung führt;
ein zweites Kühlrohr (105b), das die Strömung des Kältemittels in einer anderen Richtung führt; und
ein Umschaltrohr (105c), das zwischen dem ersten Kühlrohr (105a) und dem zweiten Kühlrohr (105b) abgerundet oder abgebogen ist,
wobei das Kältemittel nacheinander in das erste Kühlrohr (105a), das Umschaltrohr (105c) und das zweite Kühlrohr (105b) strömt.

11. Klimaanlage nach Anspruch 10, ferner mit einem Einführteil (332), das durch Aussparen mindestens einer der Wärmeableitplatten (331, 333) gebildet ist, in der das erste (105a) oder zweite Kühlrohr (105b) platziert ist.

12. Klimaanlage nach einem der Ansprüche 1 bis 11, die ferner aufweist:
einen Außenwärmetauscher (200), in dem Außenluft und das Kältemittel Wärme miteinander austauschen; und
ein Hauptexpansionsventil (260), das von dem im Außenwärmetauscher (200) kondensierten Kältemittel durchlaufen wird, wobei das Hauptexpansionsventil (260) auf einer Seite des Außenwärmetauschers (200) angeordnet ist,
wobei das Kühlrohr (105) das Kältemittel, das das Hauptexpansionsventil (260) durchläuft, zu einem Kühlmittelkanal der Wärmeableitplatte (331, 333) führt.

13. Klimaanlage nach einem der Ansprüche 1 bis 12, die ferner aufweist:
einen Unterkühlungs-Wärmetauscher (270), in den das die Wärmeableitplatte (331, 333) durchlaufende Kältemittel eingeleitet wird; und
einen Unterkühlungsverteiler (271), der auf einer Einlassseite des Unterkühlungs-Wärmetauschers (270) angeordnet ist, um das Kältemittel abzuzweigen.

## Revendications

1. Climatiseur comprenant :
une unité électronique (300) comprenant un composant de commande (355) pour entraîner un cycle de fluide frigorigène ; et
un tube de refroidissement (105) à travers lequel s'écoule un fluide frigorigène pour refroidir l'unité électronique (300), le tube de refroidissement (105) étant couplé à un côté de l'unité électronique (300),
dans lequel l'unité électronique (300) comprend :
un boîtier électronique (301) possédant une partie traversante (305, 306) ;
une carte électronique (350) à laquelle est couplé le composant de commande (355), la carte électronique (350) étant disposée dans le boîtier électronique (301) ;
une plaque de transfert de chaleur (340) disposée pour être en contact avec le composant de commande, la plaque de transfert de chaleur (340) étant couplée au boîtier électronique (301) ;
une plaque de dissipateur thermique (331, 333) à laquelle est couplé le tube de refroidissement (105), la plaque de dissipateur thermique (331, 333) étant en contact avec la plaque de transfert de chaleur (340) par le biais de la partie traversante (305, 306);
des guides de fixation (360) espaçant la carte électronique (350) de la plaque de transfert de chaleur (340), étant disposés sur le même côté de la plaque de transfert de chaleur (340) mais espacés les uns des autres au niveau d'extrémités opposées ; **caractérisé par**
des premiers organes de couplage (371) configurés pour coupler les guides de fixation (360) et la plaque de transfert de chaleur (340) à la surface intérieure du boîtier électronique (301),
dans lequel les premiers organes de couplage (371) traversent le guide de fixation (360) respectif et la plaque de transfert de chaleur (340) de manière à les coupler au boîtier électronique (301).

2. Climatiseur selon la revendication 1, dans lequel la plaque de transfert de chaleur (340) est supportée par une surface intérieure du boîtier électronique (301).

3. Climatiseur selon la revendication 1 ou 2, dans lequel le composant de commande est disposé entre la carte électronique (350) et la plaque de transfert de chaleur (340).

4. Climatiseur selon l'une quelconque des revendications 1 à 3, dans lequel chacun des guides de fixation (360) comprend :
une première partie de guidage (360a) couplée à la carte électronique (350) ; et
une seconde partie de guidage (360b) pliée pour s'étendre depuis la première partie de guidage (360a), la seconde partie de guidage (360b) étant couplée à la plaque de transfert de chaleur (340).

5. Climatiseur selon la revendication 4, comprenant en outre des écarteurs (362) couplés entre la première partie de guidage (360a) respective des guides de fixation (360) et la carte électronique (350).

6. Climatiseur selon l'une quelconque des revendications 1 à 5, comprenant en outre une pluralité de guides de couplage (365) disposés dans le boîtier électronique (301) pour supporter la plaque de transfert de chaleur (340) de telle sorte que la plaque de transfert de chaleur (340) est couplée à la surface intérieure du boîtier électronique (301).

7. Climatiseur selon la revendication 6, dans lequel la plaque de transfert de chaleur (340) est couplée séparément dans un espace entre la pluralité de guides de couplage (365).

8. Climatiseur selon l'une quelconque des revendications 1 à 7, comprenant en outre un deuxième organe de couplage (373) pour coupler la plaque de dissipateur thermique (331, 333) au boîtier électronique (301),
dans lequel le deuxième organe de couplage (373) traverse la plaque de dissipateur thermique (331, 333) et est couplé à la plaque de transfert de chaleur (340).

9. Climatiseur selon l'une quelconque des revendications 1 à 8, dans lequel la partie traversante (305, 306) comprend une première partie traversante (305) et une deuxième partie traversante (306), et
la plaque de dissipateur thermique (331, 333) comprend des première (331) et deuxième (333) plaques de dissipateur thermique qui sont respectivement couplées aux première et deuxième parties traversantes.

10. Climatiseur selon l'une quelconque des revendications 1 à 9, dans lequel le tube de refroidissement (105) comprend :
un premier tube de refroidissement (105a) guidant un écoulement du fluide frigorigène dans une direction ;
un deuxième tube de refroidissement (105b) guidant l'écoulement du fluide frigorigène dans une autre direction ; et
un tube de commutation (105c) arrondi ou plié entre le premier tube de refroidissement (105a) et le deuxième tube de refroidissement (105b),
dans lequel le fluide frigorigène s'écoule successivement dans le premier tube de refroidissement (105a), le tube de commutation (105c) et le deuxième tube de refroidissement (105b).

11. Climatiseur selon la revendication 10, comprenant en outre une partie d'insertion (332), qui est formée en évidant au moins l'une des plaques de dissipateur thermique (331, 333), dans laquelle est placé le premier (105a) ou le deuxième (105b) tube de refroidissement.

12. Climatiseur selon l'une quelconque des revendications 1 à 11, comprenant en outre :
un échangeur de chaleur extérieur (200) dans lequel l'air extérieur et le fluide frigorigène subissent un échange de chaleur l'un avec l'autre ; et
un détendeur principal (260) à travers lequel passe le fluide frigorigène condensé dans l'échangeur de chaleur extérieur (200), le détendeur principal (260) étant disposé sur un côté de l'échangeur de chaleur extérieur (200),
dans lequel le tube de refroidissement (105) guide le fluide frigorigène traversant le détendeur principal (260) jusqu'à un passage de fluide frigorigène de la plaque de dissipateur thermique (331, 333).

13. Climatiseur selon l'une quelconque des revendications 1 à 12, comprenant en outre :
un échangeur de chaleur à surrefroidissement (270) dans lequel est introduit le fluide frigorigène traversant la plaque de dissipateur thermique (331, 333) ; et
un distributeur à surrefroidissement (271) disposé sur un côté entrée de l'échangeur de chaleur à surrefroidissement (270) pour faire bifurquer le fluide frigorigène.
